Europäisches Patentamt

European Patent Office

Office européen des brevets

(11) Publication number: **0 228 694**
A2

# (12) EUROPEAN PATENT APPLICATION

(21) Application number: 86117928.1

(22) Date of filing: 23.12.86

(51) Int. Cl.⁴: **H 05 K 3/40**
**H 05 K 3/00**

(30) Priority: 30.12.85 US 814406

(43) Date of publication of application:
15.07.87 Bulletin 87/29

(84) Designated Contracting States:
DE FR GB

(71) Applicant: E.I. DU PONT DE NEMOURS AND COMPANY
1007 Market Street
Wilmington Delaware 19898(US)

(72) Inventor: Cox III, Gordon Sidney
2904 Crossfork Drive Apartment 4B
Wilmington Delaware 19808(US)

(74) Representative: Werner, Hans-Karsten, Dr. et al,
Deichmannhaus am Hauptbahnhof
D-5000 Köln 1(DE)

(54) Process using combination of laser etching and another etchant in formation of conductive through-holes in a dielectric layer.

(57) A conductive through-hole is formed through a dielectric sandwiched between conductors by forming a noncircular hole in a conductor, laser etching a pathway completely through the dielectric, liquid chemical or plasma etching the dielectric layer adjacent the pathway to undercut the conductive layer, and deforming at the conductor which has been undercut during the etching.

F I G. I D

EP 0 228 694 A2

TITLE                                    PD-2179

PROCESS USING COMBINATION OF LASER
ETCHING AND ANOTHER ETCHANT IN FORMATION OF
CONDUCTIVE THROUGH-HOLES IN A DIELECTRIC LAYER

BACKGROUND OF THE INVENTION

The present invention is directed to an improved process for forming conductive through-holes through a dielectric, i.e., an insulating layer sandwiched between two conductive layers. The process is particularly useful in the formation of printed circuit boards.

U.S. Patent 3,969,815 discloses a process for providing an electrical interconnection of two metal layers positioned on opposite sides of a substrate. A hole is initially drilled or bored completely through the two metal layers and the intermediate insulating layer. The hole in the insulating layer is enlarged by a selective etching process which only etches the insulating layer which undercuts the metal layer portions. Thereafter these overhanging metal portions on opposite sides of the insulating layer are deformed by pressure to contact or almost contact one another. The deformed metal portions are coated by galvanic metal which is overcoated by a thin layer, preferably tin, to form a conductive path.

U.S. Patent 4,472,238 discloses a process for formation of a conductive through-holes by plasma etching a hole through a dielectric sandwiched between conductors and by deforming at least one conductor which has been undercut during the etching. In U.S. Patent 4,501,638 liquid chemical etching is employed rather than plasma etching in formation of the conductive through-hole.

U.S. Patent 4,517,050 discloses a process for making an electrically conducting path in a dielectric layer sandwiched between two conductive layers by forming a noncircular hole in a conductor, etching a hole through the dielectric and by deforming the conductor which has been undercut during the etching.

As integrated circuits are formed in higher density and with more input and output connections, circuit boards must also be formed in higher density. Also, the drive to use surface mount devices requires higher density circuit boards, since more components can be placed per board. Using known processes, difficulty has been encountered in obtaining higher density without an increase in the number of circuit layers. Using the process of the invention increased board density can be obtained because decreased through-hole sizes, i.e., smaller vias, are achievable and blind vias can be formed. In the formation of multilayer circuits using the present process, vias or through-holes are formed which only exist between the two adjacent layer (blind vias). These blind vias save on space in the multilayer because they do not disturb any areas on the other layers in the multilayer circuit. This is opposite of through-holes created by mechanical drilling which produce holes which exist in all layers whether they are connected electrically or not. This uses up more space in the multilayer which could require more layers to create an equivalent circuit.

## SUMMARY OF THE INVENTION

A process for making an electrically conducting path in a dielectric layer sandwiched between two electrically conductive layers comprising

(a) forming a hole completely through at least one of the conductive layers:

(b) through said hole laser etching the dielectric layer whereby a pathway is formed completely through the dielectric layer without substantially undercutting dielectric material between the two conductive layers;

(c)     etching the dielectric layer adjacent the pathway to undercut the conductive layer adjacent the hole;

(d)     deforming the conductive layer which has been undercut toward the other conductive layer, and

(e)     forming an electrical conducting path between the two conductive layers through the pathway.

BRIEF DESCRIPTION OF THE DRAWINGS

Figure 1A is a cross-sectional view of a composite article of an electrically conductive layer, a dielectric layer and an electrically conductive layer with a hole through one conductive layer.

Figure 1B is a cross-sectional view of the article of Figure 1A with the addition of a pathway formed through the dielectric layer by laser etching.

Figure 1C is a cross-sectional view of the article of Figure 1B with the widened pathway formed by plasma or liquid etching.

Figure 1D is a cross-sectional view of the article of Figure 1C except the electrically conductive layer is deformed into the pathway in the dielectric layer.

Figure 1E is a top view of the article of Figure 1A showing an outline of a hole formed in one conductive layer.

Figure 1F is a top view of the article of Figure 1A showing another outline of a hole formed in the conductive layer.

Figure 2A is a cross-sectional view of a composite article of an electrically conductive layer, a dielectric layer and an electrically conductive layer with a hole through each of the conductive layers.

Figure 2B is a cross-sectional view of the article of Figure 2A with the addition of a pathway formed in the dielectric layer by laser-etching.

Figure 2C is a cross-sectional view of the article of Figure 2B with a widened pathway.

Figure 2D is a cross-sectional view of the article in Figure 2C except the electrically conductive layers have been deformed into the pathway in the dielectric.

DETAILED DESCRIPTION OF THE INVENTION

The present invention is particularly adapted for forming a conductive through-hole (also called pathways and vias herein), and particularly a great number of small precisely located through-holes, through a dielectric layer sandwiched between two electrically conducting materials. Generally the electrically conducting layers are metal, preferably copper, while the dielectric is generally an electrically insulating polymer.

Composites of two layers of electrically conductive material separated by a dielectric are conventional starting materials for forming circuit boards and are suitable herein. Generally the dielectric layer will be at least one mil in thickness and the conductive layer will be 0.7 to 2.8 mil (0.0018-0.0071 cm) thick, e.g., copper foil, although both thinner and thicker layers can be used. The materials of construction of the insulating layer are not critical except that they can be etched using a laser, and one other etchant such a liquid chemical etchant or plasma. Particularly preferred are polymeric dielectrics including those which are reinforced such as with glass fibers.

In the present invention hole formation is necessary in one of the conductive layers preferably

5

without any substantial removal of material of the dielectric layer. Hole formation in a conductive layer preferably employs chemical etching which is well-known in the formation of printed circuits. An example of such chemical etching involves lamination of a negative acting photosensitive film to the conductor surface which does not face the dielectric layer, exposing the photosensitive polymer to expose portions of the metal layer and the thereafter chemically etching completely through the thickness of the exposed conductive layer. This chemical etching step removes little or no material from the dielectric polymer layer. A suitable process is disclosed in Celeste U.S. Patent 3,469,982. Positive working photopolymers with processing techniques well known the art can likewise be used, e.g., Cohen and Heiart U.S. Patent 4,193,797.

An outstanding advantage of such techniques, also called photolithographic techniques, concerns the physical geometry of the holes formed in the conductive layer. Any configuration of the hole can be formed in contrast to a drilling operation which imparts only a circular configuration. A noncircular hole in the present application means the hole will not have a constant radius in contrast to a circular hole formed in a drilling operation. With noncircular hole formation, bending of the conductor is facilitated after it is undercut by removal of dielectric adjacent the hole in the conductor. However, circular holes can be employed even though they are less desirable than holes with other configurations.

The width of the noncircular holes chemically etched in the conductive layer can be small, e.g., in the range of 150 to 300 microns in width. Also chemical etching of the conductive layer can form a great number of holes simultaneously, e.g., hundreds or thousands of holes can be easily formed in a composite blank for a circuit board of a dimension of 12 inches (30.48 cm) times 12 (30.48 cm) inches. In comparison, drilling or punching of a hole is a laborious process with an increased chance of error as the number of holes increases and such process is not suited for making holes only in one conductor. Also drilling or punching of a hole generally results in a hole diameter not smaller than 325 microns.

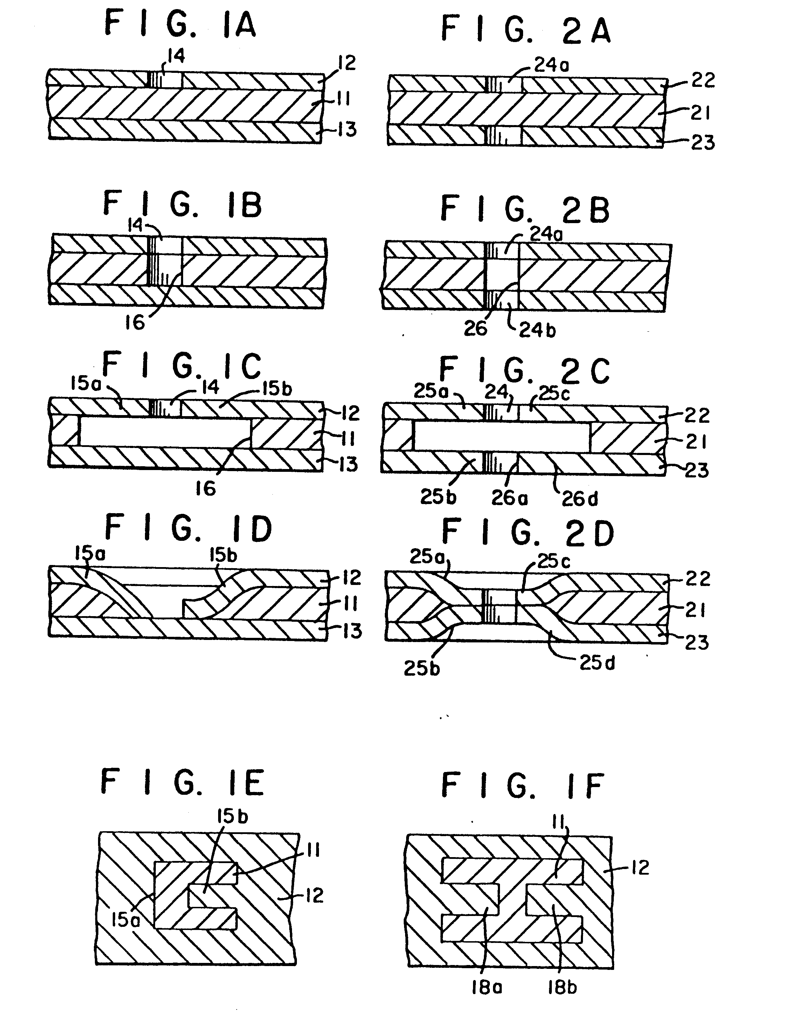

Turning to the description of the present process in conjunction with a description of the Figures, the embodiment of Figure 1A shows a composite with a hole 14 chemically etched in the conductive layer 12. The hole need not be completely circular with a suitable noncircular configuration shown in Figure 1E or Figure 1F. These latter Figures are alternate top views of the Figure 1A embodiment and show exposed insulating layer 11 beneath the conductive layer 12. Figure 1E and Figure 1F demonstrate right angles in the noncircular configuration which form tabs 15b and 18a and 18b respectively, although other angular configurations for the hole in the metal can be used. The angular configuration acts to minimize stress when the conductor adjacent the hole is bent in a subsequent operation in formation of the electrically conductive pathway through the dielectric layer.

In the present invention a selective etching process is employed to etch the dielectric layer. A laser beam is employed as a focussed laser beam such as an impulse of a pulsed infrared laser, more especially a $CO_2$ laser is suitable provided it is powerful enough to form a hole, i.e., a pathway or through-hole completely through the dielectric layer.

This selective etching process results in the composite article shown in Figure 1B with through-hole 16 formed through the dielectric layer. An example of a preferred laser is a Coherent 525 carbon dioxide laser with continuous wave emission at 10.6 μm. The electrically conductive material can be any material which is relatively unaffected by the laser beam such as a material, e.g., copper, which reflects laser light at 10.6 micron, of a carbon dioxide.

The article shown in Figure 1B is subjected to a second selective etching process further, to etch the dielectric and widen the pathway in the dielectric layer. The composite article formed thereby is shown in Figure 1C wherein overhanging portions 15a and 15b are present in the conductive layer. The tab 15b is substantially more undercut than 15a because the tab is, etched on three sides instead of one.

Two examples of etching techniques which can be employed to laterally etch and to undercut a conductive layer are liquid chemical etching and plasma etching. Liquids etching techniques by which a liquid can etch selectively through a polymeric dielectric material are well-known in the art. The etchant preferably will not cause a substantial removal of the conductive material. Suitable etchants include those disclosed in U.S. Patent 3,969,815, e.g., a sulfuric acid solution can be used for polyester and epoxide resins while a caustic alcoholic solution is suitable for a polyimide. Also etching includes use of solvents capable of removing areas of the dielectric not masked by the conductive metal without any deleterious effect on the metal may be used. Examples of solvents are tetrachloroethylene, methyl chloroform, mixture of 90% tetrachloroethylene and 10% isobutyl alcohol (by volume), and chromic acid. Liquid chemical etching is disclosed in U.S. Patent 4,501,638.

For the plasma etching technique, the metal conductive layer serves as a mask since the plasma attacks the dielectric where a hole has been formed through the conductive layer. The metal is substantially unaffected by the plasma or, at least, the etching rate of the dielectric is considerably faster than the etching rate of the conductor. Various types of plasma gases may be used. The etching gas is chosen so as to produce species which react chemically with the material to be etched to form a reaction product which is volatile. Mixtures of various plasma etch gases can also be used. Preferred gas composition to be used where the dielectric is a polyimide and the mask is copper is carbon tetrafluoride/oxygen in the ratio of from 50/50 to 10/90 by volume.

A plasma etching process which is useful in this invention is described in U.S. Patent 4,517,050.

Upon completion of the widened pathway or through-hole completely through the dielectric, the undercut conductive layer 15a and 15b is deformed to contact or come in close contact with the opposite conductive layer. A suitable method is direct pressure application on the undercut conductive portions. This article embodiment is shown in Figure 1D wherein the conductive portion 15a covers the etched dielectric surface 16 and the tab 15b extends over the lower conductor 13. Figure 1D shows the embodiment of hole function in the dielectric of Figure 1A since tab 15B is longer in Figure 1D than undercut portion 15A since the tab 15B can be undercut on three sides rather than the single side of 15a. For the construction of Figure 1F, the tabs 18a and 18b could be identical in the final article, i.e., after deformation. Thereafter, if necessary, the deformed electrically conductive material may be electrolytically plated with a metal such as copper, electrolessly plated, or soldered or welded to complete or ensure an electrically conductive path through the dielectric layer. The tab 15b greatly aids in the plating or soldering of the electrically conductive path. The formation of through-holes in accordance with the present technique allows use of thin conductive layers, e.g., of 3.0 mils (0.0076 cm) or less which cannot be used with drilling techniques in which a hole is drilled through the dielectric layer since a drilling operation would be difficult without destroying the integrity of the second conductor, i.e., a hole would be formed in this second conductive layer. A through-hole is inclusive of an opening completely through a dielectric and conductive layers on opposite surfaces of the dielectric. Such through-hole is also called a blind-via. As previously discussed a drilling operation can only make relatively large holes compared to the technique disclosed herein. Also a noncircular configuration of the initial hole in the conductive layer allows deformation or bending of the conductive layer to proceed readily and at lower pressures. Once bent, the unsupported tab will be less likely to spring back from the conductive layer 13 than in a circular hole.

In an alternate embodiment of the present invention shown in Figures 2A, 2B, 2C and 2D, holes 24a and 24b are formed in two conductive layers 22 and 23 opposite one another rather than in one conductor shown in Figure IA. Except for this change the same process steps are employed except etching of the dielectric can proceed simultaneously from opposite surfaces. Initially laser etching takes place to former hole 26. Thereafter the metal conductors are undercut at 25a, 25b, 25c and 25b. Tabs 25c and 25d are substantially more undercut since hole formation in the top and bottom conductors is similar to the Figure 1E embodiment. After completion of the chemical or plasma etching of the dielectric, undercut conductive portions are deformed toward the other respective conductive layer to make contact or approximate contact. Figure 2D illustrates the compressed conductive portions 25a, 25b, 25c and 25d in contact with the dielectric 21. With hole formation in the top and bottom conductors pursuant to the embodiment shown in Figure 1F, the tabs would be identical prior to and after the deformation step. Thereafter, if desired, electrolytic plating, electroless plating, soldering or welding may take place to ensure electrical conductivity in similar fashion as previously described.

It has been found that much smaller holes can be achieved using the process of the present invention i.e., employing a combination of laser and another etching operation particularly liquid chemical or plasma etching because the laser etches anisotropically and therefore etches the through-holes with sharp side walls. The liquid chemical or plasma etches isotropically which decreases a tendency to create a through-hole of nonuniform diameter. For example a difference was obtained for one through-hole of maximum to minimum diameter of 2 mils for the laser and plasma etched through-hole pursuant to the present invention compared to 7 mils for a plasma etched through-hole which did not employ laser etching, i.e., following the teachings of U.S. Patent 4,501,638.

11

The process of the present invention is particularly adapted to formation of multiple layers of circuitry. Illustratively after completion of a conductive path through the dielectric layer a new dielectric layer can be applied to at least one of the conductive layers and a new conductive layer can be applied to this dielectric layer. Application of the new dielectric and new conductive layers can be undertaken simultaneously to the article containing the electrically conductive through-hole, e.g., a dielectric layer and conductive layer compositive are laminated onto the conductive layer previously processed in formation of at least one through-hole. Thereafter a conductive path is formed through the newly applied dielectric layer in accordance with the technique previously disclosed.

In the following example all parts and percentages are by weight unless otherwise indicated.

EXAMPLE 1

8 inch X 9 inch (20.3 cm X 22.9 cm) double sided copper-clad panels of .006 inch (.015 cm) thick Pyralux® LF-9111 laminate (manufactured by the Du Pont Company) were laminated to both sides of a copper-clad glass epoxy board using .002 inch (.0051 cm) Pyralux® WA adhesive in a lamination press at 400 psi at 356°F (180°C) for 60 minutes to obtain a circuit board blank. Pyralux® LF 9111 contains 1 (.001 inch thick, .0025 cm) layer of Kapton® polyimide sandwiched between 2 (.001 inch thick, .0025 cm) layers of WA adhesive which are sandwiched between two layers of 1 ounce copper foil. Pyralux® WA adhesive is a thermal curing acrylic adhesive. Riston® 218R photoresist was laminated to a copper surface imagewise exposed and the unhardened resist washed away in conventional manner (using the process described in U.S. Patent 3,569,982). The copper which was exposed by the imaged and developed Riston® 218R photoresist was etched with an alkaline ammonia copper etching solution in a DEA spray etcher (manufactured by Hunt Chemical Company) to create 10 mil square holes except for a copper tab portion. These holes had the shape shown in Figure 1E. One half of the material obtained was then etched using a Coherent 525 carbon dioxide laser with CW (continuous wave) emission at 10.6 μm. The laser was held stationary and the top of the material was scanned in front of the laser with a programmable X, Y table at 8"/second with 150 watts of laser power. Air at 20 psi was blown over the surface to keep the board cool and remove debris. The whole panel was then plasma etched in a plasma etching chamber of a Branson Plasma Etcher Model 7411. A vacuum was drawn to a pressure of 50 microns and the gas comprising 70% $O_2$ and 30% $CF_4$ by volume was introduced until the chamber pressure reached 200 microns. The pump rate was 550 CFM and the gas flow rate was estimated to be 750 cc/min. The radio frequency power was turned onto a setting of 4000 watts for a duration of 35 minutes. The copper foil acted as a mask for the dielectric allowing etching to occur only where holes existed in the copper foil and a pathway was formed by laser etching, through the dielectric layer. Plasma etching widened the pathway in the dielectric layer, i.e., it undercut the copper foil removing dielectric material adjacent the hole in the foil.

The copper foil overhangs were individually collapsed with a small metal probe.

The panel was then electroplated in a conventional acid copper electroplating bath to enhance the connection. Circuit patterns were then formed in the copper foils using conventional imaging and etching techniques described in U.S. Patent 3,469,982.

EXAMPLE 2

The procedure of Example 1 was followed except laser intensity was adjusted (by changing the focus) in an attempt to optimize the conditions for laser etching. Four laser parameters, i.e., laser focus settings in number of microns out of focus 150, 200, 250 and 350 were used to laser etch half of each board with 255 through-holes for each setting. For the setting of 350 microns out of focus two laser passes were used. Hole diameters of 0.018, 0.018, 0.014 and 0.013 inch (0.046, 0.046, 0.036 and 0.033 cm) were obtained.

Through-hole yields based on electrical continuity measurements were 100, 99, 99 and 97% for the four laser conditions.

EXAMPLES 3 and 4

In a comparative process the procedure of Example 2 was followed except laser etching was not employed but only plasma etching was used. Through-hole yields based on electrically continuity measurements were 52%.

In order to determine hole diameters in the dielectric which were necessary to obtain at least a 99% yield based on electrical continuity measurement only plasma etching was employed to create various diameter holes in the dielectric. An average diameter of 0.021 inch (0.053 cm) was necessary to achieve the 99% yield.

Based on the comparative examples the laser etching clearly decreases the amount of plasma etching needed to make a conducting through-hole.

Also, much smaller diameter holes obtained by using the process of the invention instead the prior art process of only plasma etching.

CLAIMS:

14

CLAIMS:

1. A process for making an electrically conducting path in a dielectric layer sandwiched between two electrically conductive layers comprising

(a) forming a hole completely through at least one of the conductive layers;

(b) through said hole laser etching the dielectric layer whereby a pathway is formed completely through the dielectric layer without substantially undercutting dielectric material between the two conductive layers;

(c) etching the dielectric layer adjacent the pathway to undercut the conductive layer adjacent the hole;

(d) deforming the conductive layer which has been undercut toward the other conductive layer, and

(e) forming an electrical conducting path between the two conductive layers through the pathway.

2. The process of claim 1 wherein in steps (a) the hole is formed without substantially removing material from the conductive layer.

3. The process of claim 1 wherein in step (c) the etching is by a plasma.

4. The process of claim 1 wherein in step (c) the etching is by a chemical liquid etchant.

5. The process of claim 1 where a hole is formed only in one conductive layer in step (a).

6. The process of claim 5 wherein the conductive layer which does not have a hole formed therein in step (a) has a thickness not greater than 3.0 mils.

7. The process of claim 2 wherein the conductive layer is copper.

8. The process of claim 1 wherein holes are formed in the conductive layers on opposite sides of

15

the polymeric dielectric layer in step (a) and the dielectric layer is etched through the opposite holes in the conductive layers in step (b).

9. The process of claim 1 wherein the electrical connection in step (d) is formed by contact of the two conductive layers.

10. The process of claim 1 wherein the formation of the electrical connection includes application of an electrically conductive material to the conductive layer in the pathway.

11. The process of claim 1 wherein a plurality of holes are simultaneously formed in step (a) and a plurality of pathways are simultaneously formed in step (b).

FIG. 1A

FIG. 2A

FIG. 1B

FIG. 2B

FIG. 1C

FIG. 2C

FIG. 1D

FIG. 2D

FIG. 1E

FIG. 1F

0228694

1 / 1